# EUROPEAN PATENT APPLICATION

(11) **EP 0 798 831 A1**
(43) Date of publication of application: **01.10.1997**
(21) Application number: 97102802.2
(22) Date of filing: 12.09.1995
(51) Int. Cl.: H01S 3/19

(54) **Semiconductor laser and fabricating method thereof**

(30) Priority: 19.09.1994 JP 223327/94
(62) Divisional of application: 95114308.0
(71) Applicant: MITSUBISHI DENKI KABUSHIKI KAISHA, Tokyo 100 (JP)
(72) Inventor: Motoda, Takashi c/o Mitsubishi Denki K.K., 1 Mizuhara 4-cho, Itami-shi, Hyogo 664 (JP); Kato, Manabu, c/o Mitsubishi Denki K.K., 1 Mizuhara 4-cho, Itami-shi, Hyogo 664 (JP)
(74) Representative: KUHNEN, WACKER & PARTNER

(57) **Abstract**

A semiconductor laser having a multi-quantum barrier layer (14) is obtained by a process including the steps of:
supplying material gas for growing a first semiconductor layer (31) as growth gas so that the first semiconductor layer (31) is grown;
replacing the growth gas with material gas for growing a second semiconductor layer having band gap energy narrower than the band gap energy of the first semiconductor layer;
immediately after finishing replacing the first growth gas with the second growth gas replacing the growth gas for growing the second semiconductor layer with the material gas for growing the first semiconductor layer (31) so that an intermediate layer (33) and then the first semiconductor layer (31) is grown; and
said steps of successively replacing the growth gas being repeated for prescribed times.

## Description

### FIELD OF THE INVENTION

This invention relates to a semiconductor laser and a fabricating method thereof, and more particularly, to a semiconductor laser having a multi-quantum barrier (MQB) structure and a fabricating method thereof.

### BACKGROUND OF THE INVENTION

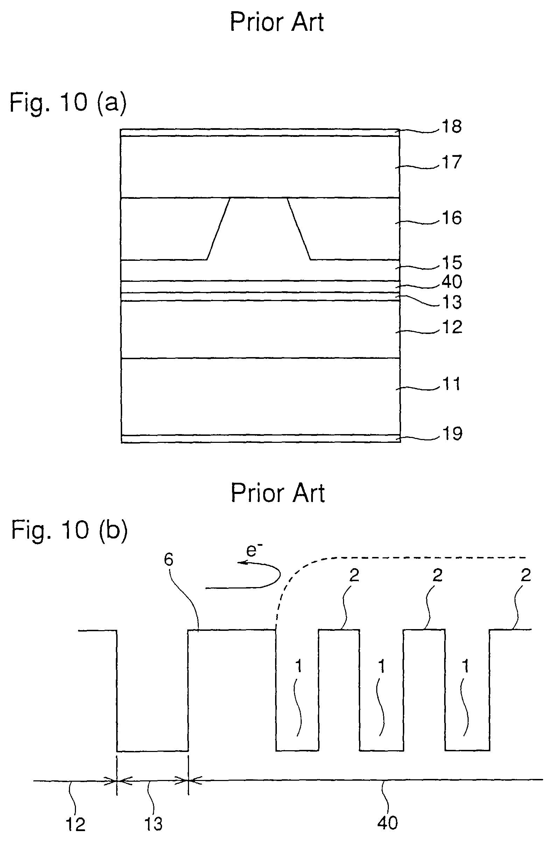

Figure 10(a) is a cross-sectional schematic view illustrating a semiconductor laser of long wavelength as an example of a prior art semiconductor laser, and figure 10(b) is a diagram illustrating band gap energy in the vicinity of the active layer of this semiconductor laser. In the figures, reference numeral 11 designates an n type InP substrate, reference numeral 12 designates an n type InP cladding layer, and reference numeral 13 designates an InGaAs active layer. Reference numeral 40 designates a multi-quantum barrier (referred to as MQB, hereinafter) structure which comprises an active layer side barrier layer 6 comprising InP and disposed in contact with the active layer 13, and well layers 1 comprising InGaAs and barrier layers 2 comprising InP which are alternately laminated with periodicity of ten or so. The active layer side barrier layer 6 is to prevent a resonance tunneling of an electron and its thickness is about 200 Å. The barrier layer 2 and the well layer 1 have a thickness of about 40 Å, respectively. Reference numeral 15 designates a p type InP cladding layer and a ridge structure is formed on its upper part. Reference numeral 16 designates an n type InP current blocking layer formed so as to bury the ridge structure, reference numeral 17 designates a p type InP contact layer, reference numeral 18 designates a p side electrode comprising Au and related materials, and reference numeral 19 designates an n side electrode comprising Au and related materials. The portion indicated by a broken line in figure 10(b) shows the effective band gap energy of the MQB structure 40.

The fabricating method will be described. First, the n type cladding layer 12, the active layer 13, the MQB structure 40, and the p type cladding layer 15 are successively formed on the semiconductor substrate 11 using MOCVD. During the formation of these layers, the MQB structure 40 is formed by first forming the active layer side barrier layer 6, and then, repeating a process of growing the well layer 1 while switching material gas and a process of growing a barrier layer 2 while again switching material gas. Next, a stripe-shaped insulating film (not shown in the figure) is formed on the p type cladding layer 15, and then, using this insulating film as a mask, the p type cladding layer 15 is etched to form the stripe-shaped ridge. Then, the n type current blocking layer 16 is formed so as to bury the ridge, the insulating film is removed, and the contact layer 17 is formed. Finally, the n side electrode 19 and the p side electrode 18 are formed on the rear surface side of the substrate 11 and on the contact layer 17, respectively, preferably by evaporation, thereby obtaining the semiconductor laser.

The operation will be described. When current is flowed through the semiconductor laser such that the n side electrode 19 is negative and the p side electrode 18 is positive, since the contact layer 17, the current blocking layer 16, and the p type cladding layer 15 form pnp structure, the current is blocked there and holes are injected from the contact layer 17 through the ridge portion of the p type cladding layer 15 and the MQB structure layer 40 into the active layer 13. Electrons are injected into the active layer 13 through the substrate 11 and the n type cladding layer 12, and the recombination of the hole and the electron occurs in the active layer 13 and laser light is produced.

The function of the MQB structure layer 40 will be described. The MQB structure layer, comprising well layers and barrier layers, is generally to enhance an effective barrier height utilizing interference of electron waves. The MQB structure layer 40 of the above semiconductor laser reflects back some of the electrons which pass through the active layer 13 and would go forward toward the p type cladding layer 15 during the electron injection into the active layer 13 so that those electrons are injected into the active layer 13, thereby performing its function of improving a light emitting efficiency of the semiconductor laser.

As described above, a prior art semiconductor laser is equipped with the MQB structure layer 40 in order to prevent the passing of the electron. In this MQB structure layer 40, since electrons are reflected back at the interface between the well layer 1 and the barrier layer 2, the steepness of this interface between the well layer 1 and the barrier layer 2 (referred to as well-barrier interface, hereinafter) has a great influence on the reflection efficiency of the electron in the MQB structure layer 40. For the MQB structure 40 of the above described prior art semiconductor laser of a long wavelength, InGaAs is used for the well layer 1 and InP is used for the barrier layer 2. Therefore, during the MQB structure layer 40 is formed, after the well layer 1 comprising the InGaAs is formed, it is necessary to completely switch from As to P, which are among the V group materials, in order to grow the barrier layer 2 comprising the InP. However, the interface control when V group materials are to be completely switched is extremely difficult. Particularly when switching from a layer including As to a layer including P, because of a carry-over of the As, it is difficult to obtain a steep interface, and it also becomes difficult to form the MQB structure layer 40 having a steep well-barrier interface. Consequently, it is difficult to improve the reflection efficiency of electron of the MQB structure layer 40 and the light emitting efficiency of the semiconductor laser cannot be improved.

In recent years, accompanied by the miniaturization of semiconductor devices in general, a need for a thinner semiconductor laser has risen and it is necessary to make the MQB structure as thin as possible in order to meet this need. However, a semiconductor laser having an MQB structure which is sufficiently thin has not been realized yet.

### SUMMARY OF THE INVENTION

It is an object of the present invention to provide a high-performance semiconductor laser having an MQB structure layer of excellent reflection efficiency of electron and a fabricating method thereof.

It is another object of the present invention to provide a thin semiconductor laser having an MQB structure which is thinner than the prior art MQB structure.

Other objects and advantages of the present invention will become apparent from the detailed description that follows. The detailed description and specific embodiments described are provided only for illustration since various additions and modifications within the scope of the invention will be apparent to those of skill in the art from the detailed description.

According to a first aspect of the present invention, a semiconductor laser has a multi-quantum barrier layer, and the multi-quantum barrier layer comprises a barrier layer of a double layer structure comprising a first barrier layer comprising a III-V group compound semiconductor material including a V group element and a second barrier layer disposed on the first barrier layer and comprising a III-V group compound semiconductor material including a V group element different from the V group element in the first barrier layer and a well layer comprising a III-V group compound semiconductor material including the same V group element as the V group element in the first barrier layer, wherein the barrier layer of the double layer structure and the well layer are alternately laminated. Therefore, it becomes unnecessary to switch the V group element at the interface of the first barrier layer and the well layer, and the interface between the first barrier layer and the well layer within the multi-quantum barrier layer can be made steep, thereby improving the reflection efficiency of electron in the multi-quantum barrier layer.

According to a second aspect of the present invention, a semiconductor laser has a multi-quantum barrier layer, and the multi-quantum barrier layer comprises a barrier layer of a double layer structure comprising a first barrier layer comprising a III-V group compound semiconductor material including a V group element and a second barrier layer disposed on the first barrier layer and comprising a III-V group compound semiconductor material including a V group element different from the V group element in the first barrier layer and a well layer comprising a III-V group compound semiconductor material including the same V group element as the V group element in the second barrier layer, wherein the barrier layer of the double layer structure and the well layer are alternately laminated. Therefore, it becomes unnecessary to switch the V group element at the interface between the second barrier layer and the well layer, and the interface between the second barrier layer and the well layer within the multi-quantum barrier layer can be made steep, thereby improving the reflection efficiency of electron in the multi-quantum barrier layer.

According to a third aspect of the present invention, a semiconductor laser has a multi-quantum barrier layer, and the multi-quantum barrier layer comprises a barrier layer of a triple layer structure comprising a first barrier layer comprising a III-V group compound semiconductor material including a V group element, a second barrier layer disposed on the first barrier layer and comprising a III-V group compound semiconductor material including a V group element different from the V group element in the first barrier layer, and a third barrier layer disposed on the second barrier layer and comprising a III-V group compound semiconductor material including the same V group element as the V group element in the first barrier layer, and a well layer comprising a III-V group compound semiconductor material including the same V group element as the V group element in the first barrier layer, wherein the barrier layer of the triple layer structure and the well layer are alternately laminated. Therefore, it becomes unnecessary to switch the V group element at the interface between the barrier layer and the well layer, and the interface between the barrier layer and the well layer within the multi-quantum barrier layer can be made steep, thereby improving the reflection efficiency of electron in the multi-quantum barrier layer.

According to a fourth aspect of the present invention, a semiconductor laser has a multi-quantum barrier layer, and the multi-quantum barrier layer comprises a barrier layer of a double layer structure comprising a first barrier layer comprising a III-V group compound semiconductor material including a V group element and a second barrier layer disposed on the first barrier layer and comprising a III-V group compound semiconductor material including a V group element different from the V group element in the first barrier layer and a well layer of a double layer structure comprising a first well layer comprising a III-V group compound semiconductor material including the same V group element as the V group element in the second barrier layer and a second well layer disposed on the first well layer and comprising a III-V group compound semiconductor material including the same V group element as the V group element in the first barrier layer, wherein the barrier layer of the double layer structure and the well layer of the double layer structure are alternately laminated. Therefore, it becomes unnecessary to completely switch the V group element at the interface of the second barrier layer and the first well layer, and it also becomes unnecessary to switch the V group element at the interface between the first barrier layer and the second well layer, and the interface between the barrier layer and the well layer within the multi-quantum barrier layer can be made steep, thereby improving the reflection efficiency of electron in the multi-quantum barrier layer.

According to a fifth aspect of the present invention, a semiconductor laser has a multi-quantum barrier layer, and the multi-quantum barrier layer comprises a barrier layer comprising a III-V group compound semiconductor material including a V group element and a well layer of a double layer structure comprising a first well layer comprising a III-V group compound semiconductor material including a V group element different from the V group element in the barrier layer and a second well layer disposed on the first well layer and comprising a III-V group compound semiconductor material including the same V group element as the V group element in the barrier layer, wherein the barrier layer and the well layer of the double layer structure are alternately laminated. Therefore, it becomes unnecessary to switch the V group element at the interface between the barrier layer and the second well layer, and the interface between the barrier layer and the second well layer within the multi-quantum barrier layer can be made steep, thereby improving the reflection efficiency of electron in the multi-quantum barrier layer.

According to a sixth aspect of the present invention, a semiconductor laser has a multi-quantum barrier layer, and the multi-quantum barrier layer comprises a barrier layer comprising a III-V group compound semiconductor material including a V group element and a well layer of a double layer structure comprising a first well layer comprising a III-V group compound semiconductor material including the same V group element as the V group element in the barrier layer and a second well layer disposed on the first well layer and comprising a III-V group compound semiconductor material including a V group element different from the V group element in the barrier layer, wherein the barrier layer and the well layer of the double layer structure are alternately laminated. Therefore, it becomes unnecessary to switch the V group element at the interface between the barrier layer and the first well layer, and the interface between the barrier layer and the first well layer within the multi-quantum barrier layer can be made steep, thereby improving the reflection efficiency of electron in the multi-quantum barrier layer.

According to a seventh aspect of the present invention, a semiconductor laser has a multi-quantum barrier layer, and the multi-quantum barrier layer comprises a barrier layer comprising a III-V group compound semiconductor material including a V group element, a well layer of a triple layer structure comprising a first well layer comprising a III-V group compound semiconductor material including the same V group element as the V group element in the barrier layer, a second well layer disposed on the first well layer and comprising a III-V group compound semiconductor material including the same V group element as the V group element in the barrier layer, and a third well layer disposed on the second well layer and comprising a III-V group compound semiconductor material including the same V group element as the V group element in the barrier layer, wherein the barrier layer and the well layer of the triple layer structure are alternately laminated. Therefore, it becomes unnecessary to switch the V group element at the interface between the barrier layer and the well layer, and the interface between the barrier layer and the well layer within the multi-quantum barrier layer can be made steep, thereby improving the reflection efficiency of electron in the multi-quantum barrier layer.

According to an eighth aspect of the present invention, a semiconductor laser has a multi-quantum barrier layer, and the multi-quantum barrier layer comprises a barrier layer comprising a III-V group compound semiconductor material including a V group element and a well layer comprising a III-V group compound semiconductor material including the same V group element as the V group element in the barrier layer, wherein the barrier layer and the well layer are alternately laminated. Therefore, it becomes unnecessary to switch the V group element at the interface between the barrier layer and the well layer, and the interface between the barrier layer and the well layer within the multi-quantum barrier layer can be made steep, thereby improving the reflection efficiency of electron in the multi-quantum barrier layer.

According to a ninth aspect of the present invention, a semiconductor laser has a multi-quantum barrier layer, and a method of fabricating the multi-quantum barrier layer includes supplying material gas for growing a first semiconductor layer as growth gas so that the first semiconductor layer is grown, replacing the growth gas with material gas for growing a second semiconductor layer having band gap energy narrower than the band gap energy of the first semiconductor layer, and immediately after finishing replacing the growth gas for growing the first semiconductor layer with the material gas for growing the second semiconductor layer, replacing the growth gas for growing the second semiconductor layer with the material gas for growing the first semiconductor layer so that the first semiconductor layer is grown, wherein the processes of successively replacing the growth gas are repeated for prescribed times. Therefore, the thickness of the multi-quantum barrier layer can be reduced.

According to a tenth aspect of the present invention, the semiconductor laser described as in the ninth aspect of the present invention has the multi-quantum barrier layer, and the method of fabricating the multi-quantum barrier layer further includes halting the process of growing each of the first semiconductor layers which are repeated for prescribed times immediately after each first semiconductor layer formed thereby becomes devoid of materials for the second semiconductor layer. Therefore, the thickness of the multi-quantum barrier layer can be reduced.

According to an eleventh aspect of the present invention, in a method of fabricating a semiconductor laser, a method of fabricating a multi-quantum barrier layer includes the steps of successively forming a first barrier layer comprising a III-V compound semiconductor material including a V group element and a second barrier layer comprising a III-V group compound semiconductor material including a V group element different from the V group element in the first barrier layer and forming a well layer comprising a III-V group compound semiconductor material including the same V group element as the V group element in the first barrier layer, wherein the process of successively forming the first barrier layer and the second barrier layer and the process of forming the well layer are repeated for prescribed times. Therefore, it becomes unnecessary to switch the V group element at the interface between the first barrier layer and the well layer, and the interface between the first barrier layer and the well layer within the multi-quantum barrier layer can be made steep, thereby improving the reflection efficiency of electron in the multi-quantum barrier layer.

According to a twelfth aspect of the present invention, in a method of fabricating a semiconductor laser, a method of fabricating a multi-quantum barrier layer includes the steps of successively forming a first barrier layer comprising a III-V group compound semiconductor material including a V group element and a second barrier layer comprising a III-V group compound semiconductor material including a V group element different from the V group element in the first barrier layer and forming a well layer comprising a III-V group compound semiconductor material including the same V group element as the V group element in the second barrier layer, wherein the process of successively forming the first barrier layer and the second barrier layer and the process of forming the well layer are repeated for prescribed times. Therefore, it becomes unnecessary to switch the V group element at the interface between the second barrier layer and the well layer, and the interface between the second barrier layer and the well layer within the multi-quantum barrier layer can be made steep, thereby improving the reflection efficiency of electron in the multi-quantum barrier layer.

According to a thirteenth aspect of the present invention, in a method of fabricating a semiconductor laser, a method of fabricating a multi-quantum barrier layer includes the steps of successively forming a first barrier layer comprising a III-V group compound semiconductor material including a V group element, a second barrier layer comprising a III-V group compound semiconductor material including a V group element different from the V group element of the first barrier layer, and a third barrier layer comprising a III-V group compound semiconductor material including the same V group element as the V group element in the first barrier layer, and forming a well layer comprising a III-V group compound semiconductor material including the same V group element as the V group element in the first barrier layer, wherein the process of successively forming the first barrier layer, the second barrier layer, and the third barrier layer and the process of forming the well layer are repeated for prescribed times. Therefore, it becomes unnecessary to switch the V group element at the interface between the barrier layer and the well layer, and the interface between the barrier layer and the well layer within the multi-quantum barrier layer can be made steep, thereby improving the reflection efficiency of electron in the multi-quantum barrier layer.

According to a fourteenth aspect of the present invention, in a method of fabricating a semiconductor laser, a method of fabricating a multi-quantum barrier layer includes the steps of successively forming a first barrier layer comprising a III-V group compound semiconductor material including a V group element and a second barrier layer comprising a III-V group compound semiconductor material including a V group element different from the V group element in the first barrier layer and successively forming a first well layer comprising a III-V group compound semiconductor material including the same V group element as the V group element in the second barrier layer and a second well layer comprising a III-V group compound semiconductor material including the same V group element as the V group element in the first barrier layer, wherein the process of successively forming the first barrier layer and the second barrier layer and the process of successively forming the first well layer and the second well layer are repeated for prescribed times. Therefore, it becomes unnecessary to completely switch the V group element at the interface between the second barrier layer and the first well layer, and it also becomes unnecessary to switch the V group element at the interface between the first barrier layer and the second well layer, and the interface between the barrier layer and the well layer within the multi-quantum barrier layer can be made steep, thereby improving the reflection efficiency of electron in the multi-quantum barrier layer.

According to a fifteenth aspect of the present invention, in a method of fabricating a semiconductor laser, a method of fabricating a multi-quantum barrier layer includes the steps of forming a barrier layer comprising a III-V group compound semiconductor material including a V group element and successively forming a first well layer comprising a III-V group compound semiconductor material including a V group element different from the V group element in the barrier layer and a second well layer comprising a III-V group compound semiconductor material including the same V group element as the V group element in the barrier layer, wherein the process of forming the barrier layer and the process of successively forming the first well layer and the second well layer are repeated for prescribed times. Therefore, it becomes unnecessary to switch the V group element at the interface between the barrier layer and the second well layer, and the interface between the barrier layer and the second well layer within the multi-quantum barrier layer can be made steep, thereby improving the reflection efficiency of electron in the multi-quantum barrier layer.

According to a sixteenth aspect of the present invention, in a method of fabricating a semiconductor laser, a method of fabricating a multi-quantum barrier layer includes the steps of forming a barrier layer comprising a III-V group compound semiconductor material including a V group element and successively forming a first well layer comprising a III-V group compound semiconductor material including the same V group element as the V group element in the barrier layer and a second well layer disposed on the first well layer and comprising a III-V group compound semiconductor material including a V group element different from the V group element in the barrier layer, wherein the process of forming the barrier layer and the process of successively forming the first well layer and the second well layer are repeated for prescribed times. Therefore, it becomes unnecessary to switch the V group element at the interface between the barrier layer and the first well layer, and the interface between the barrier layer and the well layer within the multi-quantum barrier layer can be made steep, thereby improving the reflection efficiency of electron in the multi-quantum barrier layer.

According to a seventeenth aspect of the present invention, in a method of fabricating a semiconductor laser, a method of fabricating a multi-quantum barrier layer includes the steps of forming a barrier layer comprising a III-V group compound semiconductor material including a V group element and successively forming a first well layer comprising a III-V group compound semiconductor material including the same V group element as the V group element in the barrier layer, a second well layer comprising a III-V group compound semiconductor material including a V group element different from the V group element in the barrier layer, and a third well layer comprising a III-V group compound semiconductor material including the same V group element as the V group element in the barrier layer, wherein the process of forming the barrier layer and the process of successively forming the first well layer, the second well layer, and the third well layer are repeated for prescribed times. Therefore, it becomes unnecessary to switch the V group element at the interface between the barrier layer and the well layer, and the interface between the barrier layer and the well layer within the multi-quantum barrier layer can be made steep, thereby improving the reflection efficiency of electron in the multi-quantum barrier layer.

According to an eighteenth aspect of the present invention, in a method of fabricating a semiconductor laser, a method of fabricating a multi-quantum barrier layer includes the steps of forming a barrier layer comprising a III-V group compound semiconductor material including a V group element and forming a well layer comprising a III-V group compound semiconductor material including the same V group element as the V group element in the barrier layer, wherein the barrier layer and the well layer being alternately laminated. Therefore, it becomes unnecessary to switch the V group element at the interface between the barrier layer and the well layer, and the interface between the barrier layer and the well layer within the multi-quantum barrier layer can be made steep, thereby improving the reflection efficiency of electron in the multi-quantum barrier layer.

According to a nineteenth aspect of the present invention, a method of fabricating a semiconductor laser includes a method of fabricating a multi-quantum barrier layer, and the method of fabricating the multi-quantum barrier layer includes the steps of supplying material gas for growing a first semiconductor layer as growth gas so that the first semiconductor layer is grown, replacing the growth gas with material gas for growing a second semiconductor layer having band gap energy narrower than the band gap energy of the first semiconductor layer, and immediately after finishing replacing the growth gas for growing the first semiconductor layer with the material gas for growing the second semiconductor layer, replacing the growth gas for growing the second semiconductor layer with the material gas for growing the first semiconductor layer so that the first semiconductor layer is grown, wherein the processes of successively replacing the growth gas are repeated for prescribed times. Therefore, the thickness of the multi-quantum barrier layer can be reduced.

According to a twentieth aspect of the present invention, in the method of fabricating the semiconductor laser as described in the nineteenth aspect of the present invention, the method of fabricating the multi-quantum barrier layer further includes the step of halting the process of growing each of the first semiconductor layers which are repeated for prescribed times immediately after the first semiconductor layer formed thereby becomes devoid of materials for the second semiconductor layer. Therefore, the thickness of the multi-quantum barrier layer can be reduced.

### BRIEF DESCRIPTION OF THE DRAWINGS

Figure 1(a) is a cross-sectional view illustrating a semiconductor laser according to a first embodiment of the present invention, and figure 1(b) is a diagram illustrating band gap energy in the vicinity of a multi-quantum barrier structure of the semiconductor laser.

Figure 2 is a diagram illustrating band gap energy in the vicinity of a multi-quantum barrier structure of another semiconductor laser according to the first embodiment of the present invention.

Figure 3 is a diagram illustrating band gap energy in the vicinity of a multi-quantum barrier structure of a semiconductor laser according to a second embodiment of the present invention.

Figure 4 is a diagram illustrating band gap energy in the vicinity of a multi-quantum barrier structure of a semiconductor laser according to a first modification of the second embodiment of the present invention.

Figure 5 is a diagram illustrating band gap energy in the vicinity of a multi-quantum barrier structure of a semiconductor laser according to a second modification of the second embodiment of the present invention.

Figure 6 is a diagram illustrating band gap energy in the vicinity of a multi-quantum barrier structure of a semiconductor laser according to a third embodiment of the present invention.

Figure 7 is a diagram illustrating band gap energy in the vicinity of a multi-quantum barrier structure of a semiconductor laser according to a fourth embodiment of the present invention.

Figures 8(a)-8(b) are diagrams illustrating band gap energy in the vicinity of a multi-quantum barrier structure of a semiconductor laser according to a fifth embodiment of the present invention.

Figures 9(a)-9(b) are diagrams illustrating band gap energy in the vicinity of a multi-quantum barrier structure of a prior art semiconductor laser, which are referred to in conjunction with the description of a structure of a semiconductor laser according to a fifth embodiment of the present invention.

Figure 10(a) is a cross-sectional view illustrating a prior art semiconductor laser, and figure 10(b) is a diagram illustrating band gap energy in the vicinity of a multi-quantum barrier structure of the prior art semiconductor laser.

Figure 11 is a diagram illustrating band gap energy in the vicinity of a multi-quantum barrier structure of a semiconductor laser according to a first modification of the third embodiment of the present invention.

Figure 12 is a diagram illustrating band gap energy in the vicinity of a multi-quantum barrier structure of a semiconductor laser according to a second modification of the third embodiment of the present invention.

Figure 13 is a multi-quantum barrier structure of a semiconductor laser according to a third modification of the third embodiment of the present invention.

### DETAILED DESCRIPTION OF THE PREFERRED EMBODIMENTS

### [Embodiment 1]

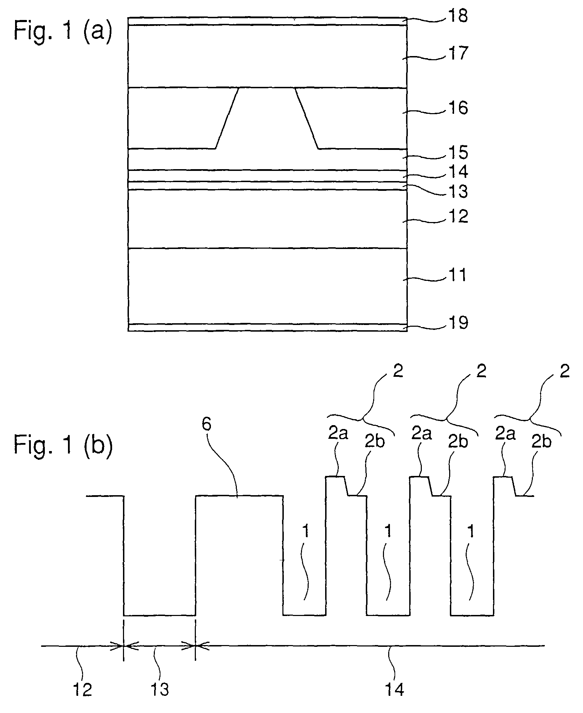

Figure 1(a) is a cross-sectional view illustrating a semiconductor laser according to a first embodiment of the present invention, and figure 1(b) is a structural diagram of band gap energy in the vicinity of an active layer and a multi-quantum barrier (also referred to as MQB, hereinafter) structure layer of the semiconductor laser. In the figures, reference numeral 11 designates an n type InP substrate, reference numeral 12 designates an n type InP cladding layer, reference numeral 13 designates an InGaAs active layer, reference numeral 14 designates a multi-quantum barrier (MQB) structure which comprises an active layer side barrier layer 6 comprising InP and disposed in contact with the active layer 13, and InGaAs well layers 1 and barrier layers 2 which are alternately laminated with periodicity of ten or so. The active layer side barrier layer 6 is to prevent a resonance tunneling of an electron and its thickness is about 200 Å. The well layer 1 and the barrier layer 2 have a thickness of about 40 Å, respectively. The barrier layer 2 comprises a GaAs barrier layer 2a and an InP barrier layer 2b laminated with the GaAs barrier layer 2a being on the active layer 13 side, and the thickness of the GaAs barrier layer 2a is 5-10 Å. Reference numeral 15 designates a p type InP cladding layer the upper portion of which forms a ridge structure, reference numeral 16 designates an n type InP current blocking layer formed so as to bury the ridge structure, reference numeral 17 designates a p type InP contact layer, reference numeral 18 designates a p side electrode comprising Au and related materials, and reference numeral 19 designates an n side electrode comprising Au and related materials.

A fabricating method will be described. First, the n type cladding layer 12, the active layer 13, the MQB structure 14, and the p type cladding layer 15 are successively formed on the semiconductor substrate 11 using metal organic chemical vapor deposition (MOCVD) while switching material gases. During the formation of these layers, the MQB structure 14 is formed by first forming the active layer side barrier layer 6 and, then, repeating a process of forming the well layer 1 while switching material gas and a process of first forming the GaAs barrier layer 2a while switching material gas and then forming the InP barrier layer 2b while again switching material gas. Next, a stripe-shaped insulating film (not shown in the figure) is formed on the p type cladding layer 15, and, using this insulating film as a mask, the p type cladding layer 15 is etched to form the stripe-shaped ridge. Then, the n type current blocking layer 16 is formed so as to bury the ridge. After the insulating film is removed, the contact layer 17 is formed, and the n side electrode 19 and the p side electrode 18 are formed on the rear surface side of the substrate 11 and on the contact layer 17, respectively, thereby completing the semiconductor laser.

The operation of the semiconductor laser will be described. When current is flowed through the semiconductor laser such that the n side electrode 19 is negative and the p side electrode 18 is positive, since the contact layer 17, the current blocking layer 16, and the p type cladding layer 15 form pnp structure, the current is blocked there and holes are injected from the contact layer 17 through the ridge portion of the p type cladding layer 15 and the MQB structure layer 14 into the active layer 13. Electrons are injected into the active layer 13 through the substrate 11 and the n type cladding layer 12, and the recombination of the hole and the electron occurs in the active layer 13 and laser light is produced.

The multi-quantum barrier structure of this first embodiment will be described. The barrier layer 2 of the multi-quantum barrier (MQB) structure 14 of this embodiment is a double layer structure, the one on the active layer 13 side being the GaAs barrier layer 2a and the other on the p type cladding layer 15 side being the InP barrier layer 2b. The formation of the MQB structure 14 having such barrier layer 2 of the double layer structure is, as previously described, accomplished by repeating the process of forming the well layer 1, then growing the GaAs barrier layer 2a while switching material gas, then growing the InP barrier layer 2b while switching material gas, and again growing the well layer 1 while switching material gas. During this process, the process of growing the barrier layer 2a after the growth of the well layer 1 is to switch from the growth of InGaAs to the growth of GaAs, and a switch from the barrier layer 2b to the well layer 1 is to switch from InP to InGaAs. Therefore, if the MQB structure 14 is structured as above, the growth which includes a switch from a layer including As to a layer including P, thereby making the interface control particularly difficult, does not have to take place at the interface between the well layer 1 and the barrier layer 2 (also referred to as well-barrier interface, hereinafter), and the steepness of the well-barrier interface can be improved. Although a switch from the layer including As to the layer including P takes place when switching from the growth of the GaAs barrier layer 2a of the barrier layer 2 to the InP barrier layer 2b, since it is not necessary to reflect back electrons at the interface of the GaAs barrier layer 2a and the InP barrier layer 2b, this interface does not have to be steep.

As described above, the steepness of the well-barrier interface in the MQB structure can be improved, the reflection efficiency of electron at the MQB structure can be improved, and a high-performance semiconductor laser having excellent light emitting efficiency can be obtained in this first embodiment.

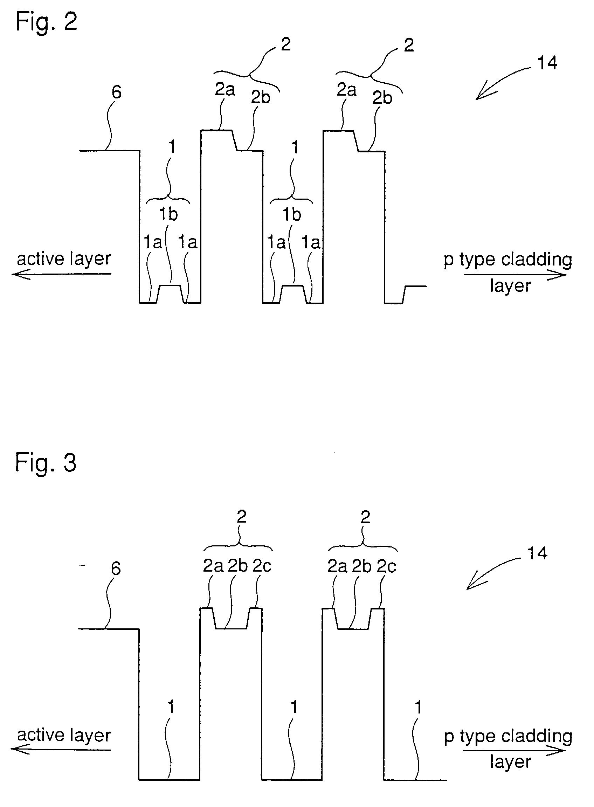

While, in the first embodiment, a single layer of InGaAs is used as the well layer 1, this invention can be applied to a case where the well layer 1 of the semiconductor laser of the first embodiment shown in figure 1(b) has a triple layer structure which is realized by inserting an InGaAsP well layer 1b between the InGaAs well layers 1a as shown in figure 2, and the similar effect as in the first embodiment can be obtained in this case. Furthermore, the well layer 1 can be made to have a multiple layer structure which is realized by inserting a plurality of layers comprising prescribed materials between the InGaAs well layers 1a, and the similar effect as in the first embodiment can be obtained.

While, in the first embodiment, the case where InGaAs is used as a material for the well layer 1 is described, this invention can be applied to a case where other materials such as InAs is used for the well layer 1, and the similar effect as in the above embodiment can be obtained. Particularly, when InGaAsP is used as a material for the well layer 1, it becomes possible to form the InGaAsP well layer without switching off P, the V group material gas, after the InP barrier layer 2b is formed. The steepness of the interface between the InP barrier layer 2b and the well layer 1 can be improved and a semiconductor laser of better light emitting efficiency can be obtained.

### [Embodiment 2]

Figure 3 is a diagram illustrating band gap energy of the principal part of an MQB structure of a semiconductor laser according to a second embodiment of the present invention. In the figure, the same reference numerals used in figures 1(a)-1(b) are to designate the same or similar parts. Reference numeral 2c designates a GaAs barrier layer. The semiconductor laser of the second embodiment is the same as the one in the first embodiment except that the GaAs barrier layer 2c is formed between the InP barrier layer 2b and the well layer 1 in the MQB structure 14, making a triple layer structure for the barrier layer 2.

For the semiconductor laser of the second embodiment, a switch from the growth of the well layer 1 to the growth of the barrier layer 2 of the MQB structure 14 becomes a switch from InGaAs to GaAs as in the first embodiment, and a switch from the growth of the barrier layer 2 to the growth of the well layer 1 of the MQB structure 14 becomes a switch from GaAs to InGaAs. Because of this, the growth which includes a switch from a layer including As to a layer including P, making the interface control particularly difficult, does not have to take place at the well-barrier interface. A switch from a layer including P to a layer including As does not have to take place at the well-barrier interface, either, and the well-barrier interface can be made to have much better steepness. Although the growth of layers which requires a switch of V group elements, that is, the growth of layers requiring a switch from the GaAs barrier layer 2a including As to the InP barrier layer 2b including P, and the growth of layers requiring a switch from the InP barrier layer 2b including P to the GaAs barrier layer 2c including As take place within the barrier layer 2, it is not necessary to reflect electrons at the interfaces between these layers, and therefore, even though these interfaces are not steep, the characteristics of the barrier layer 2 is not affected.

As described above, in the second embodiment, the similar effect as in the first embodiment can be obtained, the interface switching from the barrier layer 2 to the well layer 1 can be made steep, and a high-performance semiconductor laser having better light emitting efficiency can be obtained.

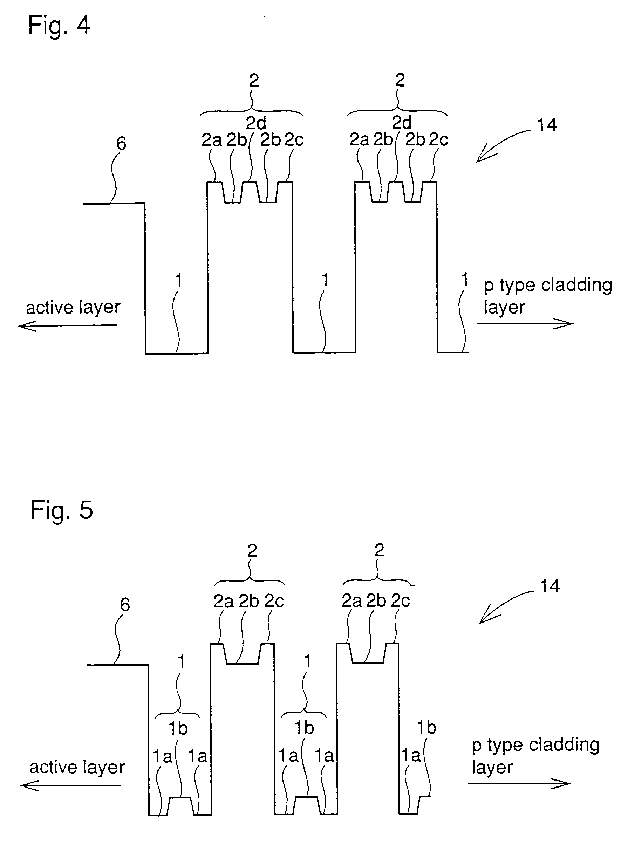

While, in the second embodiment, the case where the barrier layer 2 has a triple layer structure is described, a plurality of other layers can be disposed inside the InP barrier layer 2b of the barrier layer 2 in this invention. For example, as shown in figure 4, the GaAs barrier layer 2d can be disposed inside the InP barrier layer 2b of a semiconductor laser which has the same structure as in the second embodiment, and the similar effect as in the second embodiment can be obtained.

While, in the second embodiment, the case where a single layer of InGaAs is used as the well layer 1 is described, the well layer 1 of the semiconductor laser of the second embodiment can be made to have a triple layer structure instead of a single layer of InGaAs, where the InGaAsP well layer 1b is inserted between the InGaAs well layers 1a in this invention. The similar effect as in the second embodiment can also be obtained in this case.

### [Embodiment 3]

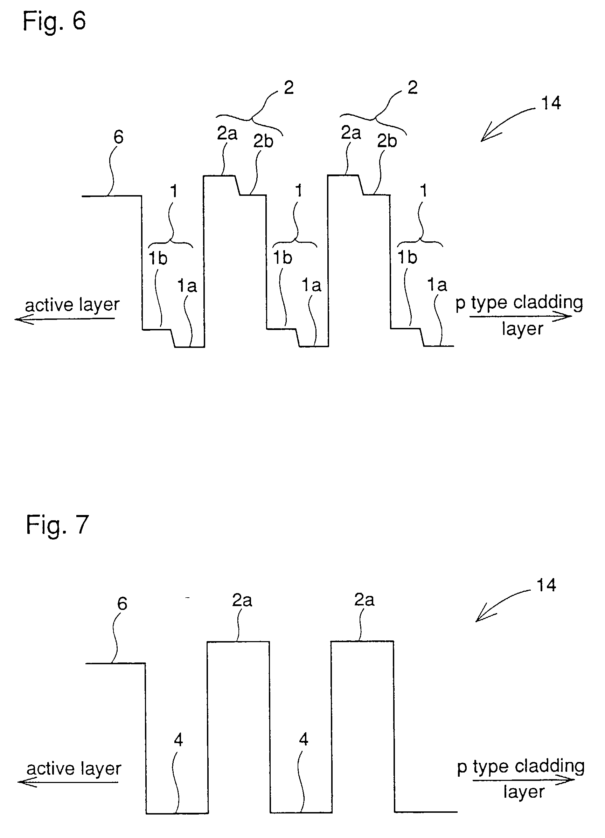

Figure 6 is a diagram illustrating band gap energy of the principal part of an MQB structure of a semiconductor laser according to a third embodiment of the present invention. In the figure, the same reference numerals used in the figures 1(a)-1(b) designate the same or similar parts. Reference numeral 1a designates an InGaAs well layer and reference numeral 1b designates an InGaAsP well layer.

The semiconductor laser of the third embodiment is the same as the one in the first embodiment except that the well layer 1 of the MQB structure 14 has a double layer structure comprising the InGaAsP well layer 1b being on the substrate 11 side and the InGaAs well layer 1a being on the p type cladding layer 15 side. In this structure, a switch from the growth of the well layer 1 to the growth of the barrier layer 2a is conducted by switching from InGaAs to GaAs as in the first embodiment, and a switch from the growth of the InP barrier layer 2b to the growth of the InGaAsP well layer 1b is conducted by switching from InP to InGaAsP. Therefore, when switching from the barrier layer 2 to the well layer 1, since a complete switch from P element to As element becomes unnecessary, the steepness of the growth interface where the well layer 1 switches to the barrier layer 2 can be improved, and the growth interface where the barrier layer 2 switches to the well layer 1 can be made to have excellent steepness, thereby providing a high-performance semiconductor laser.

In this embodiment, the InP barrier layer of a single layer can be used as the barrier layer of the MQB structure instead of having the barrier layer 2 of the double layer structure comprising the GaAs barrier layer 2a and the InP barrier layer 2b illustrated in the first embodiment, and the well layer of the triple layer structure obtained by sandwiching the InGaAsP well layer 1b with the InGaAs well layers 1a can be used as the well layer 1. In this case, since it also becomes unnecessary to completely switch from P element to As element at the growth interface between the well layer 1 and the barrier layer 2, the growth interface where the well layer 1 switches to the barrier layer 2 as well as the growth interface where the barrier layer 2 switches to the well layer 1 can be made to have excellent steepness, and a high-performance semiconductor laser can be provided.

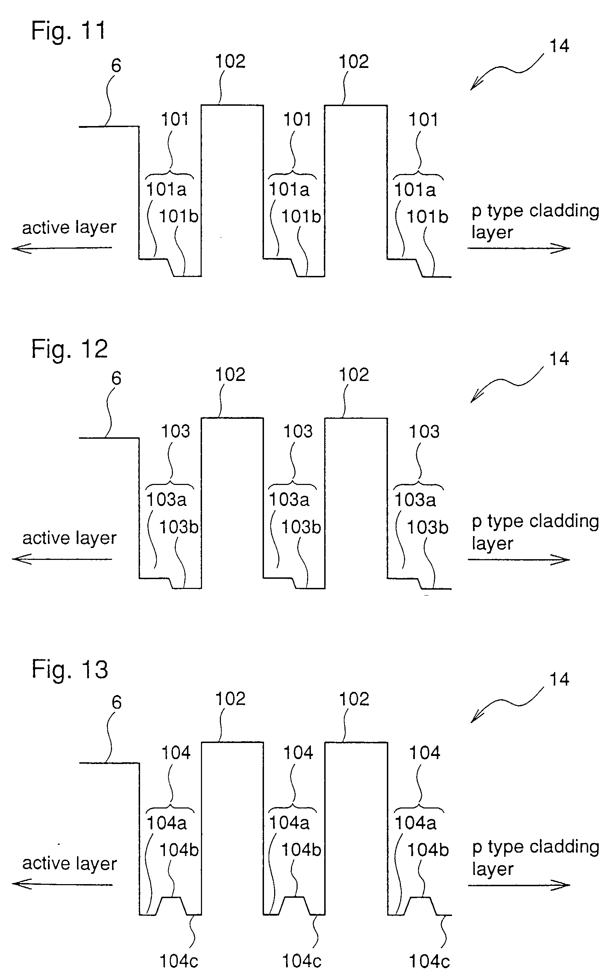

While, in the third embodiment of the present invention, the case in which the multi-quantum barrier layer comprises the barrier layer 2 of the double layer structure comprising the GaAs barrier layer 2a and the InP barrier layer 2b and the well layer 1 of the double layer structure comprising the InGaAsP well layer 1b and the InGaAs well layer 1a is described, the present invention can be applied, as shown in figure 11, to a case in which the multi-quantum barrier structure comprises a barrier layer 102 comprising a III-V group compound semiconductor material including a V group element and a well layer of a double layer structure, the double layer structure comprising a first well layer 101a comprising a III-V group compound semiconductor material including a V group element different from the V group element in the barrier layer and a second well layer 101b disposed on the first well layer 101a and comprising a III-V group compound semiconductor material including the same V group element as the V group element in the barrier layer 102, and the barrier layer and the well layer being alternately laminated. The similar effect as in the third embodiment can be obtained even in this case.

While, in the third embodiment of the present invention, the case in which the multi-quantum barrier layer comprises the barrier layer 2 of the double layer structure comprising the GaAs barrier layer 2a and the InP barrier layer 2b and the well layer 1 of the double layer structure comprising the InGaAsP well layer 1b and the InGaAs well layer 1a is described, the present invention can be applied, as shown in figure 12, to a case in which the multi-quantum barrier layer structure comprises a barrier layer 102 and a well layer of a double layer structure, the double layer structure comprising a first well layer 103a comprising a III-V group compound semiconductor material including the same V group element as the V group element in the barrier layer 102 and a second well layer 103b disposed on the first well layer 103a and comprising a III-V group compound semiconductor material including a V group element different from the V group element in the barrier layer 102, and the barrier layer and the well layer being alternately laminated. In this case, the growth interface at which the second well layer 103b switches to the barrier layer 102 becomes of the excellent steepness and a high performance semiconductor laser can be provided.

While, in the third embodiment of the present invention, the case in which the multi-quantum barrier layer comprises the barrier layer 2 of the double layer structure comprising the GaAs barrier layer 2a and the InP barrier layer 2b and the well layer 1 of the double layer structure comprising the InGaAsP well layer 1b and the InGaAs well layer 1a is described, the present invention can be applied, as shown in figure 13, to a case in which the multi-quantum barrier layer comprises a barrier layer 102 comprising a III-V group compound semiconductor material including a V group element and a well layer of a triple layer structure, the triple layer structure comprising a first well layer 104a comprising a III-V group compound semiconductor material including the same V group element as the V group element in the barrier layer, a second well layer 104b disposed on the first well layer 104a and comprising a III-V group compound semiconductor material including the same V group element as the V group element in the barrier layer 102, and a third well layer 104c disposed on the second well layer 104b and comprising a III-V group compound semiconductor material including the same V group element as the V group element in the barrier layer 102, and the barrier layer and the well layer being alternately laminated. The similar effect as in the third embodiment can be obtained even in this case.

### [Embodiment 4]

Figure 7 is a diagram illustrating band gap energy of the principal part of an MQB structure of a semiconductor laser according to a fourth embodiment of the present invention. In the figure, the same reference numerals used in figures 1(a)-1(b) designate the same or similar parts. Reference numeral 4 designates an InAs well layer.

The semiconductor laser of the fourth embodiment is the same as the one in the first embodiment except that the well layer 4 comprising InAs is used instead of the well layer 1 comprising InGaAs of the MQB structure 14, and that the barrier layer 2a of a single layer solely comprising GaAs is used instead of the barrier layer 2 of a double layer structure comprising the GaAs barrier layer 2a and the InP barrier layer 2b. Because of this structure, the growth of the barrier layer 2a after the well layer 4 and the growth of the well layer 4 after the barrier layer 2a are conducted by switching from InAs to GaAs or the other way around. Therefore, since it is not necessary to perform a switching growth from a layer including As to a layer including P or the other way around, which makes the interface control particularly difficult, and only the switching growth between In and Ga is necessary, the steepness of the well-barrier interface can be made excellent, the reflection efficiency of electrons at the MQB structure 14 can be improved, and a high-performance semiconductor laser having the excellent light emitting efficiency can be provided.

While, in the fourth embodiment, the InAs well layer 4 and the GaAs barrier layer 2a are used for the well layer and the barrier layer, respectively, two different materials which include a common V group element as their constituents and have different band gap energies can be used for the barrier layer and the well layer in this invention. For example, an InP layer and a GaP layer can be used for the well layer and the barrier layer, respectively. Then, it is not necessary to switch off the V group element, that is P, when switching from the growth of the well layer to the growth of the barrier layer or the other way around, and the similar effect as in the fourth embodiment can be obtained.

While, in the above first, second, third, and fourth embodiments, semiconductor lasers comprising InP and related materials are described, this invention can be applied to semiconductor lasers comprising other III-V group compound semiconductors and related materials, and the similar effects as in each of the previous embodiments can be obtained in this case.

### [Embodiment 5]

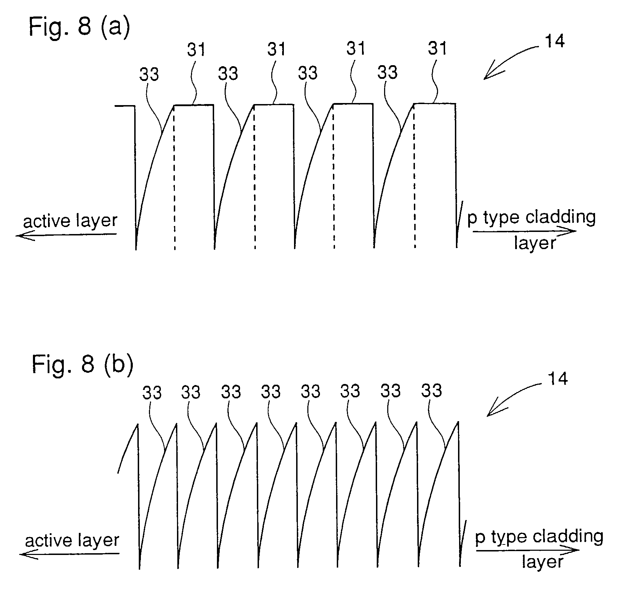

Figures 8(a)-8(b) are diagrams illustrating band gap energy of the principal part of an MQB structure of a semiconductor laser according to a fifth embodiment of the present invention. In the figures, reference numeral 31 designates an InP barrier layer and reference numeral 33 designates an intermediate layer. The semiconductor laser in the fifth embodiment is the same as the one in the first embodiment except that the structure of the MQB structure 14 of the semiconductor laser is modified.

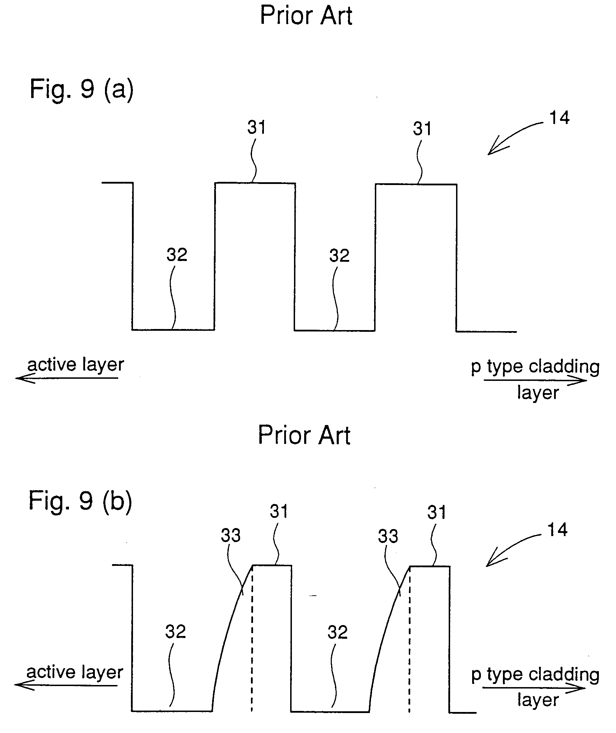

Figures 9(a)-9(b) are schematic diagrams illustrating band gap energy of an MQB structure of a prior art semiconductor laser in conjunction with the description of the semiconductor laser according to the fifth embodiment of the present invention. In the figures, the same reference numerals used in figures 8(a)-8(b) designate the same or similar parts. Reference numeral 32 designates an InAs well layer.

The structure will be described. The MQB structure 14 of the prior art semiconductor laser comprises the InAs well layers 32 and the InP barrier layers 31 arranged with prescribed periodicity as shown in figure 9(a), and electrons are reflected back at the steep interface between the well layer 32 and the barrier layer 31, preventing the electrons from passing through. Since it was previously thought that the interface between the well layer 32 and the barrier layer 31 was steep, it was necessary to have the well layer 32 of a prescribed thickness.

However, as in the structure of the prior art semiconductor laser previously described, it is actually difficult to make the interface which is switching from the InAs well layer 32 to the InP barrier layer 31 to be an interface at which band gap energy changes steeply. Consequently, an intermediate layer 33 whose composition gradually changes from InAs to InP is formed on the active layer 13 side of the barrier layer 31. In the MQB structure 14 having the structure such as this, electrons are reflected only at the interface where the InP barrier layer 31 changes to the InAs well layer 32.

In the fifth embodiment, the InP barrier layer 31 is formed and, then, immediately after the material gas is switched to the one to form the InAs well layer 32, the material gas is again switched to the one to form the barrier layer 31 and the barrier layer 31 is formed. Its band gap energy is illustrated in figure 8(a). In the MQB structure 14 of the semiconductor laser of this embodiment, the interface at which the barrier layer 31 is switched to the intermediate layer 33 becomes a steep interface, and electrons are reflected back at this interface. Because of this, the intermediate layer 33 serves as the well layer, which eliminates the need for the disposition of the well layer, and a semiconductor laser having the MQB structure 14 which is thinner than the prior art MQB structure by the amount of the well layer can be provided.

In this embodiment as described above, the semiconductor laser having the MQB structure 14 fabricated by repeating for prescribed times the process of forming the InP barrier layer 31 and, then, immediately after switching the material gas to the one to form the InAs well layer 32, switching the material gas to the one to form the barrier layer 31, thereby forming the barrier layer 31 again. Therefore, a semiconductor laser which is thinner than a prior art semiconductor laser can be obtained.

In the fifth embodiment, the intermediate layer 33 is formed and, then, the barrier layer 31 is formed. However, the MQB structure 14 can be formed by repeating for prescribed times the processes of forming the intermediate layer 33 and, immediately after that, switching the material gas to the one to form the well layer and, immediately after that, switching the material gas to the one to form the barrier layer, thereby forming the intermediate layer 33 again, so that the MQB structure 14 having band gap energy of a jagged edge shape as shown in figure 8(b) is formed. For these processes, since the time required for the intermediate layer 33 to be completely formed since the introduction of the gas for forming the barrier layer depends on the apparatus to be used for its growth, the time interval most suited must be determined beforehand preferably by experimentation. Since in the MQB structure 14 having the structure such as this, the interface between the adjoining intermediate layers 33 becomes a steep interface, electrons are reflected at this interface. Therefore, the structure 14 functions as an MQB structure and, since it becomes unnecessary to dispose the barrier layer, the semiconductor laser having the MQB structure which is thinner than a prior art MQB structure by the amount equal to the sum of the well layers and the barrier layers can be provided.

While the case where the present invention is applied to a semiconductor laser of long wavelength comprising InP and related materials is described in the fifth embodiment, the present invention can be applied to semiconductor lasers of short wavelength and of visible wavelength or to semiconductor lasers comprising III-V group compound semiconductor materials and II-VI group compound semiconductor materials. The similar effect as in the fifth embodiment can also be obtained in these cases.

While, in the first, second, third, fourth, and fifth embodiments, the case where the n type semiconductor substrate is used and electrons are prevented from passing in the MQB structure is described, the present invention can also be applied to a case where a p type semiconductor substrate is used and holes are prevented from passing in the MQB structure, and the similar effects as in each of the previous embodiments can be obtained. In this case, it is necessary to design the MQB structure such that the composition of the MQB structure prevents holes from passing.

Furthermore, while, in the first, second, third, fourth, and fifth embodiments, the case where the MQB structure is disposed in contact with the active layer and electrons are prevented from passing in the MQB structure is described, the MQB structure can be formed in other positions within the semiconductor laser in this invention, and a high-performance semiconductor laser can be provided. For example, the MQB structure can be formed between the cladding layer and the current blocking layer, and by preventing electrons or holes by the MQB structure from passing, it is possible to decrease leak current more securely.

## Claims

1. A semiconductor laser having a multi-quantum barrier layer (14), said multi-quantum barrier layer (14) being obtainable by a process including the steps of:
supplying material gas for growing a first semiconductor layer (31) as growth gas so that the first semiconductor layer (31) is grown;
replacing the growth with material gas for growing a second semiconductor layer having band gap energy narrower than the band gap energy of the first semiconductor layer;
immediately after finishing replacing the growth gas for growing the first semiconductor layer (31) with the material gas for growing the second semiconductor layer, replacing the growth gas for growing the second semiconductor layer with the material gas for growing the first semiconductor layer (31) so that the first semiconductor layer (31) is grown; and
said steps of successively replacing the growth gas being repeated for prescribed times.

2. The semiconductor laser of claim 1 having said multi-quantum barrier layer (14), said multi-quantum barrier layer (14) being obtainable by said process, said process further including the step of halting the process of growing each of the first semiconductor layers which are repeated for prescribed times immediately after each first semiconductor layer formed thereby becomes devoid of materials for the second semiconductor layer.

3. A method of fabricating a semiconductor laser including a method of fabricating a multi-quantum barrier layer (14), said method of fabricating the multi-quantum barrier layer (14) including the steps of:
supplying material gas for growing a first semiconductor layer (31) as growth gas so that the first semiconductor layer (31) is grown;
replacing the growth gas with material gas for growing a second semiconductor layer having band gap energy narrower than the band gap energy of the first semiconductor layer (31);
immediately after finishing replacing the growth gas for growing the first semiconductor layer (31) with the material gas for growing the second semiconductor layer, replacing the growth gas for growing the second semiconductor layer with the material gas for growing the first semiconductor layer (31) so that the first semiconductor layer (31) is grown; and
said steps of successively replacing the growth gas being repeated for prescribed times.

4. The method of fabricating the semiconductor laser of claim 3, said method of fabricating the multi-quantum barrier layer (14) further including the step of halting the process of growing each of the first semiconductor layers which are repeated for prescribed times immediately after the first semiconductor layer formed thereby becomes devoid of materials for the second semiconductor layer.
